# EUROPEAN PATENT SPECIFICATION

(11) **EP 2 345 145 B1**
(45) Date of publication and mention of the grant of the patent: **25.05.2016**
(21) Application number: 09819805.4
(22) Date of filing: 07.10.2009
(51) Int. Cl.: H02N 2/00, H02N 2/18, A43B 3/00

(54) **FOOT-POWERED FOOTWEAR-EMBEDDED SENSOR-TRANSCEIVER**
IM EINEM SCHUH EINGEBETTETER, FUSSBETÄTIGTER SENSOR-SENDEEMPFÄNGER
CAPTEUR-ÉMETTEUR/RÉCEPTEUR INCORPORÉ DANS UNE CHAUSSURE ET ALIMENTÉ À LA FORCE DU PIED

(30) Priority: 08.10.2008 US 103756 P
(43) Date of publication of application: 20.07.2011
(73) Proprietor: Sapurast Research LLC, Wilmington, DE 19801 (US)
(72) Inventor: KEATING, Joseph A., Broomfield Colorado 80020 (US); BRADOW, Timothy N., Littleton Colorado 80127 (US); JOHNSON, Raymond R., Denver Colorado 80224 (US); NARAYAN, Prativadi B., Broomfield Colorado 80020 (US)
(74) Representative: Barnfather, Karl Jon
(86) International application number: PCT/US2009/059817
(87) International publication number: WO 2010/042601

(56) References cited:
- WO-A1-2007/016781
- US-A1- 2004 078 662
- US-A1- 2006 021 261
- US-A1- 2006 046 907
- US-A1- 2006 046 907
- US-A1- 2007 264 564
- US-B1- 6 255 799
- US-B1- 6 433 465
- US-B1- 6 433 465
- US-B2- 6 768 246
- US-B2- 7 162 392

## Description

### TECHNICAL FIELD AND BACKGROUND OF THE INVENTION

US 2006/046907 is considered as the closest prior art to the subject-matter of claim 1. This invention relates to an apparatus, method, and system for communicating data. More particularly, this invention relates to a footwear-implantable device which may be powered by harvesting energy from the use of footwear by a walking or running pedestrian and may be stored and/or converted to communication signals to transmit information.

As electronics have become smaller and more durable, there has been a progression towards incorporating electrical devices into clothing or other accessories capable of being worn on the human body. Some examples of such applications include footwear containing light-emitting diodes, ski and snowboard boot heating devices, jackets with a control panel for cell phone or MP3 players and clothing containing continuous heart-rate monitoring devices.

The current technology requires that the electronics have a source of energy to operate. This energy source is typically a battery, which can be embedded within the electronics and configured for a single use, configured to be replaceable, or configured to be rechargeable. Each of these current options has shortcomings, as the embedded battery may render the associated electronics less useful once the battery is discharged or damaged, replaceable batteries require additional space and material to hold the battery, and an externally rechargeable battery requires additional material for a connecting plug and a battery charger. Each of these options is not ideal, as consumers, particularly athletes, tend to demand equipment and clothing that is lighter and without additional power cords.

Thus, a demand exists to have a wearable electronic device that does not include large batteries and, for example, may be able to generate its own energy.

Certain athletic events require rigorous training which demands that athletes keep track of specific statistics in order to achieve optimal performance. For example, current training manuals for persons wishing to compete in marathons strongly suggest that trainees keep records of, at a minimum, their heart rate, pace, routes taken, distance, time, and the weather conditions through which they train. Through such record keeping, marathon trainees can remain focused on reaching the benchmarks that have been set out for them in order to ensure they achieve their goal race pace.

Thus, a demand exists to have all possible pieces of data relating to the performance of their bodies when training for events such as marathons.

In the case of military personnel, it is important to monitor location, physical conditions, ground conditions, and weather conditions to ensure the safety of troops both in this country and abroad. Military personnel need all information pertinent to their surroundings available on little or no prior notice.

Thus, a demand exists to have all data relevant to military operations easily accessible at all times.

### SUMMARY OF INVENTION

Pedestrians impart energy onto, for example, footwear each time he or she walks, jogs, or runs, which presents an opportunity to harness a small portion of the energy expended by incorporating an energy-harvesting device within, for example, footwear. Depending on the application, the harvested energy may be used instantaneously or stored in a component such as a battery and used at defined time intervals or when requested by a remote device.

It is one object of certain exemplary embodiments of this invention to use an energy-harvester, such as a piezoelectric mechanism, to harvest energy from the footsteps of a footwear-pedestrian and use that energy to recharge a device such as a battery that is located such that it is, for example, an integral and/or inseparable part of the footwear.

The present invention may include, for example, a unique arrangement of a microcontroller, a power management unit, a signal transmitter, a signal receiver, a thin-film battery and an energy-harvester. In some embodiments, the energy-harvester may be a piezoelectric sensor that converts motion/vibration energy into electric energy, wherein the converted energy may be used to recharge a battery, thereby providing power to a signal receiver/transmitter. In another embodiment, the piezoelectric mechanism may perform a dual function as a converter of motion energy to electrical energy and also a pedometer.

Certain embodiments of the present invention are also included in a system having a transmitter for transmitting a message to an external receiver. The system may also have sensors that may be monitored by a microcontroller. Certain signals from the sensor may be processed by the microcontroller and the processed information may be transmitted to a receiver that is located on the pedestrian or remotely, such as along the path of the pedestrian's course or on a satellite.

In another embodiment of the invention, the portable receiving device may process the information received and then send a signal back to the footwear, directing it to take an appropriate action. For example, if the number of steps taken reaches a specified number, the portable device may send a signal to the footwear to become softer or stiffer.

In a different embodiment of the invention, the footwear may transmit a signal to a GPS satellite to determine the geographical location of the footwear-pedestrian. In another embodiment of the invention, the GPS satellite may send a signal back to the footwear to direct the footwear-pedestrian to take a different route or make any other announcement.

For improved performance in this application, also disclosed is a manufacturing process for a thin-film battery having a heat and pressure-resilient separation layer for incorporating the battery cell into a printed circuit board.

### BRIEF DESCRIPTION OF DRAWING

Some features and advantages of the invention are described with reference to the drawing of a certain preferred embodiment, which is intended to illustrate and not to limit the invention.

The accompanying drawings, which are included to provide a further understanding of the invention and are incorporated in and constitute a part of this specification, illustrate exemplary embodiments of the invention that together with the description serve to explain the principles of the invention:
Figure 1 is a diagram of an embodiment of the present invention showing a pedestrian using the device.
Figure 2 is a detailed view of an article of footwear having the device embedded according to and embodiment of the present invention.
Figure 3 is a diagram of an embodiment of the present invention showing the subcomponents of the device.
Figure 4 is a diagram of an embodiment of the present invention showing the step-by-step construction of the device.

### DETAILED DESCRIPTION OF PREFERRED EMBODIMENTS

It is to be understood that the present invention is not limited to the particular methodology, compounds, materials, manufacturing techniques, uses, and applications described herein, as these may vary. It is also to be understood that the terminology used herein is used for the purpose of describing particular embodiments only, and is not intended to limit the scope of the present invention. It must be noted that as used herein and in the appended claims, the singular forms "a," "an," and "the" include the plural reference unless the context clearly dictates otherwise. Thus, for example, a reference to "an element" is a reference to one or more elements, and includes equivalents thereof known to those skilled in the art. Similarly, for another example, a reference to "a step" or "a means" is a reference to one or more steps or means and may include sub-steps or subservient means. All conjunctions used are to be understood in the most inclusive sense possible. Thus, the word "or" should be understood as having the definition of a logical "or" rather than that of a logical "exclusive or" unless the context clearly necessitates otherwise. Structures described herein are to be understood also to refer to functional equivalents of such structures. Language that may be construed to express approximation should be so understood unless the context clearly dictates otherwise.

Unless defined otherwise, all technical and scientific terms used herein have the same meanings as commonly understood by one of ordinary skill in the art to which this invention belongs. Preferred methods, techniques, devices and materials are described although any methods, techniques, devices, or materials similar or equivalent to those described may be used in the practice or testing of the present invention. Structures described herein are to be understood also to refer to functional equivalents of such structures.

All patents and other publications are incorporated herein by reference for the purpose of describing and disclosing, for example, the methodologies described in such publications that might be useful in connection with the present invention. These publications are provided solely for their disclosure prior to the filing date of the present application. Nothing in this regard should be construed as an admission that the inventors are not entitled to antedate such disclosure by virtue of prior invention or for any other reason.

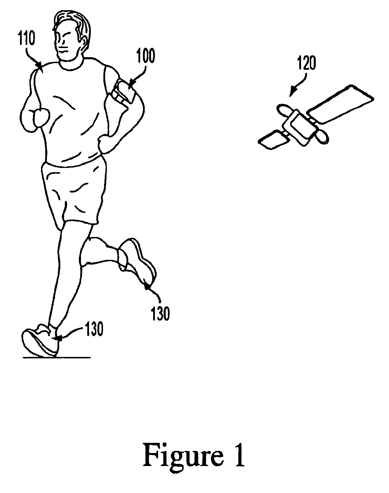

Figure **1** shows an overall diagram of an embodiment of the present invention. In this diagram, there is a pedestrian **110** with a portable electronic device **100** and a GPS satellite **120.** The pedestrian is wearing footwear **130** with the device embedded within. When the pedestrian **110** walks, jogs, runs, or otherwise takes steps, that movement imparts pressure on the shoe that is converted into useful energy. That conversion is performed by an energy-harvesting device located within the footwear **130.** The device in the footwear **130** may then, for example, send signals to a portable electronic device **100** which may process the information and store it or send the information back to the footwear **130** so that the footwear **130** itself may perform some action. The pedestrian **110** may be wearing headphones through which the pedestrian **110** may be given any information received by the portable device **100** in the form of audible messages. The device may also receive a signal from a GPS satellite **120** so the geographic location of the pedestrian **110** may be determined, the pedestrian **110** may be instructed to take an alternate route, or the pedestrian **110** may be provided with other relevant information.

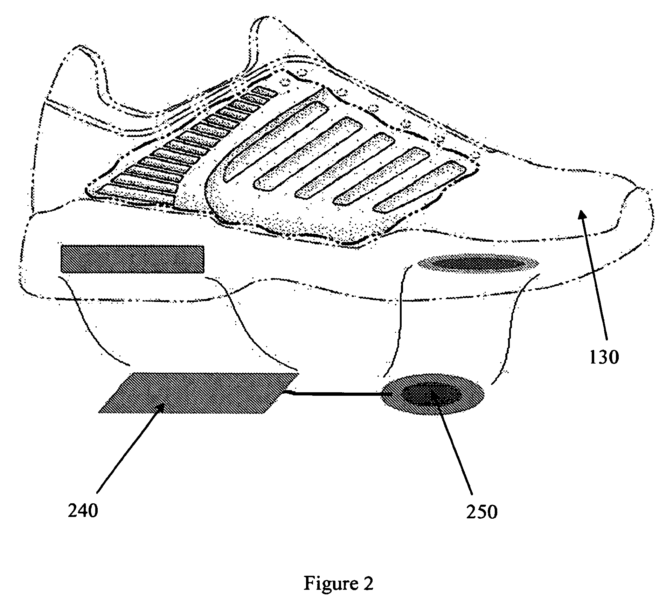

Figure **2** shows another preferred embodiment of the present invention with footwear **130** containing the embedded circuitry of a microprocessor, an energy-harvesting mechanism **250,** a power management unit and an energy storage device **240.** Although not shown, some embodiments of the present invention may have a signal transmitter and/or a signal receiver that may potentially be integrated or separately connected to the present invention. When integrated or separately connected, the transmitter may send signals from the footwear device to an external receiver such as a portable electronic device. The receiver may obtain information thereby instructing the footwear **130** or the pedestrian to take some sort of action. When integrated within the device, the receiver may receive signals from one or more GPS satellites so that the pedestrian's geographic location may be determined. In some embodiments, the energy-harvester **250** is a piezoelectric disk, but may also be a radiofrequency transducer, or a device that can convert solar power, wind power, vibration, pedestrian activity such as walking or jogging, water movement, temperature variations or rotational movements into usable energy such as electricity. The energy storage device **240,** which may be a thin-film battery, may be used to store the harvested energy such that it can be used at some pre-determined time or when requested by a remote device. In several embodiments, the thin-film battery may contain a metallic lithium anode. In some embodiments, the thin-film battery may not contain a metallic lithium anode at some point during its lifetime but may be a Li-ion or a Li-free thin-film battery.

Figure 2 shows one particular embodiment where a power management unit and energy storage device **240** are located on the back, heel portion of the footwear **130** and a microprocessor and energy harvesting mechanism **250** are located on the front, toe portion of the footwear **130.** The embedded circuitry of the microprocessor, energy harvesting mechanism **250,** power management unit and energy storage device **240** may be located in other places on the footwear **130.** In some embodiments of the present invention, the power management unit, energy storage device **240,** microprocessor and energy harvesting mechanism **250** are incorporated into one module such that they may be placed together as a unit in any location on the footwear **130.**

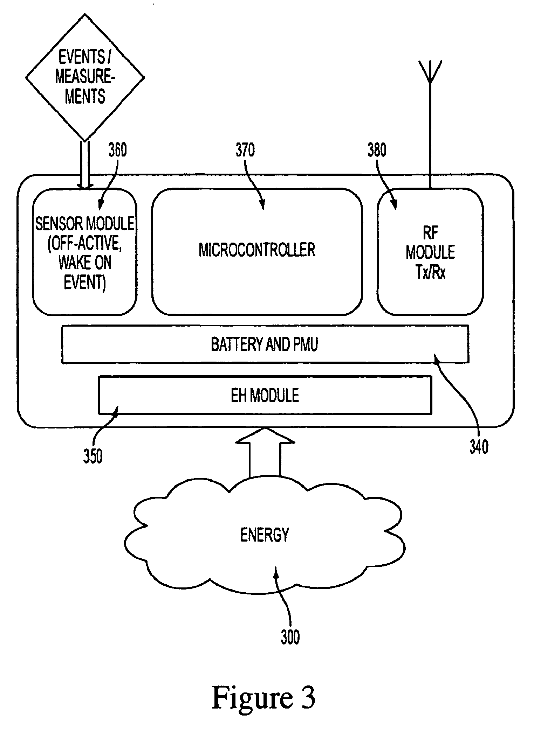

Figure **3** shows the detailed process occurring within an embodiment of the footwear **130.** The mechanical energy **300,** resulting from the pedestrian walking with the footwear **130,** may be collected by the energy harvesting module **350.** The harvested energy then recharges a rechargeable energy storage device **340** under the monitoring and regulation of the power management unit **340** or may be simply stored within the energy storage device **340.** The energy storage device **340** may store the energy and, when needed, power the microcontroller **370** and the transmitter and/or receiver **380** depending on whether a signal is being sent out, received or both.

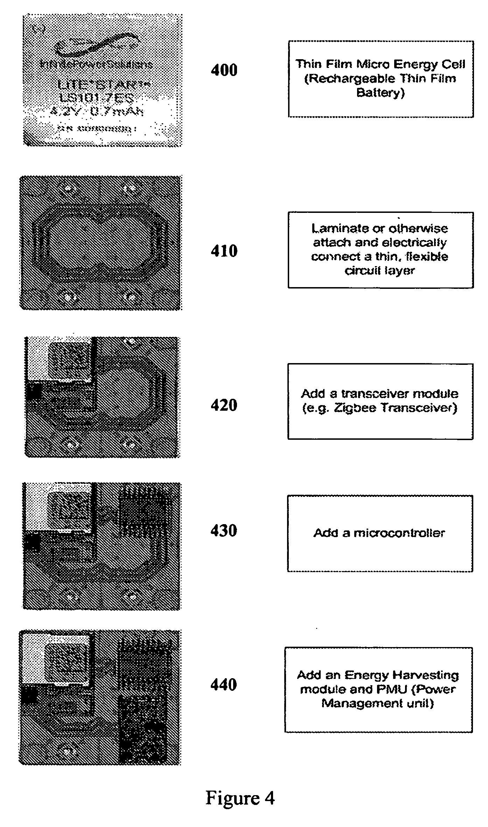

Figure **4** shows the steps that may be used to construct an embodiment of the present invention on a flexible substrate. Step **400** in this example begins with using an energy storage device, shown as a thin-film battery in the exemplary embodiment, as the centerpiece of construction. Step **410** attaches and electrically connects a flexible substrate to the energy storage device. Step **420** may be to add a transmitter/receiver mechanism to the flexible substrate, followed by the step **430** of placing a microcontroller onto the flexible substrate and the connecting the microcontroller to the transmitter/receiver mechanism. The last step **440** may be to add an energy harvesting mechanism and power management unit to the flexible substrate.

In addition to an electrochemical storage device, such as a battery or thin-film battery, the energy storage component may be an electrical storage device such as a capacitor or thin-film capacitor, but may also be a mechanical energy storage device, such as, for example, a flywheel, micro-flywheel, micro electro-mechanical system (MEMS), or a mechanical spring. The energy storage component may also be an electro-mechanical device, such as a piezoelectric element or a magneto-electric element, similar to the invention disclosed in U.S. Patent No. 7,088,031, entitled "Method and Apparatus for an Ambient Energy Battery or Capacitor Recharge System" which is herein incorporated by reference in its entirety. The energy storage component may also be a thermal energy storage device, such as a thermal mass container, or it could be a chemical energy storage device, such as, for example, a hydrogen generator with hydrogen container or an ozone generator with ozone container. Each one of these devices may be used to store energy in accordance with one or more exemplary elements of the system. An energy harvester may also be provided, which may include, for example, a device to convert specific types of ambient energy into electrical energy, which may then be stored in an electrochemical storage device such as, for example, a battery or capacitor.

In some embodiments, the system in the footwear contains a sensor 360 that may transmit a signal through the transmitter to a portable device. In some embodiments, the portable device may be a wristwatch but may also be a personal digital assistant or a cell phone. The portable device may also be an iPod®, MP3 player or other digital audio player or a combination of the above and may even receive signals from one or more GPS satellites.

In some embodiments, one or more sensors may measure any number of different physical qualities. In some embodiments, one sensor may be measuring the weather in which case it may be, for example, a thermometer to measure the temperature, a hydrometer to measure the humidity, an anemometer to measure the velocity or pressure of the wind or a barometer to measure the atmospheric pressure. A barometer in combination with a microprocessor may be able to detect changes in pressure and predict changes in the weather and provide a warning to the pedestrian. In several embodiments, one sensor may be used to measure pressure and determine changes in altitude. In some embodiments, one sensor may also measure the speed of a pedestrian, such as, for example, by using an accelerometer.

In some embodiments where the energy storage device is a thin-film battery, the thin-film battery may have a thickness that does not exceed 1 cm and a lateral area that may be less than 10 square inches. In another embodiment, the lateral area of the thin-film battery may be less than 0.25 square centimeters.

In some embodiments, the thin-film battery may have a heat and pressure-resilient separation layer for purposes of incorporating the battery cell into the printed circuit board manufacturing process.

In the several embodiments in which the energy storage device is a rechargeable device, such as, for example, a thin-film battery, this will present an opportunity whereby the present invention may be capable of performing nearly indefinitely. The present invention may allow for energy created through a pedestrian walking or performing any other type of motion to be harvested in an energy harvesting mechanism and for that harvested energy to ensure that the rechargeable energy storage device is so charged.

In some embodiments, the portable electronic device may process the information received and then send a signal back to the footwear to take an appropriate action. An appropriate action could include, for example, the portable electronic device sending a signal to the footwear to become more or less stiff in order to relax the foot after a specified number of steps have been taken.

In some embodiments, the footwear may receive a signal from one or more GPS satellites to determine the geographic location, direction, and speed of the footwear-pedestrian. In another embodiment, in combination with stored maps, the GPS satellite may send back a signal to the footwear to give the footwear-pedestrian an instruction, such as, for example, to take a different route.

This invention has been described herein in several embodiments. It is evident that there are many alternatives and variations that can embrace the performance of ceramics enhanced by the present invention in its various embodiments without departing from the intended spirit and scope thereof. The embodiments described above are exemplary only. One skilled in the art may recognize variations from the embodiments specifically described here, which are intended to be within the scope of this disclosure. As such, the invention is limited only by the following claims. Thus is intended that the present invention cover the modifications of this invention provided they come within the scope of the appended claims and their equivalents.

## Claims

1. An apparatus comprising:
an accessory (130) adapted to be worn by a moving human (110);
an energy harvesting mechanism (250) embedded within said accessory and adapted to convert a force applied to the accessory by the moving human (110) to a harvested energy;
an energy storage device (240) connected to said energy-harvesting mechanism (250) and adapted to receive the harvested energy from the energy harvesting mechanism (250) and store the harvested energy;
a receiver (380) to receive a signal from a portable device (100) which is positioned on the human (110) who is wearing the accessory and a power management unit (340) connected to said energy storage device (240);
a microprocessor (370) is embedded within the accessory and is connected to said energy storage device (240) and is adapted to change an operating condition in the accessory (130) in response to the signal received from the portable electronic device (100).

2. The apparatus of claim 1, wherein said accessory (130) comprises any article selected from the group of: shoe, sandal, slipper, boot, alpine ski, water ski, surfboard, snow board, roller skate, inline skate, sled, horse shoe, horse saddle, harness, leash, collar.

3. The apparatus of claim 1, further comprising at least one sensor, at least one signal transmitter that transmits a message to the portable device (100) and the signal receiver is adapted to receive GPS signals, connected to said microprocessor (370).

4. The apparatus of claim 1, wherein said energy-harvesting mechanism (250) comprises any device selected from the group of: piezoelectric transducer, radiofrequency transducer, solar cell, wind turbine, vibration energy scavenger, water movement-to-electric energy converter, rotational movement-to-electric energy converter, and temperature variation-to-electric energy converter.

5. The apparatus of claim 3, wherein said at least one sensor comprises any device selected from the group of: altimeter, pressure gauge, thermometer, barometer, hygrometer, accelerometer, anemometer.

6. The apparatus of claim 1, wherein said energy storage device comprises any device selected from the group of: battery, thin-film battery, capacitor, thin-film capacitor, magneto-electric element, piezoelectric element, thermal mass container, flywheel, micro-flywheel, micro electro-mechanical system (MEMS), mechanical spring, hydrogen generator with hydrogen container, ozone generator with ozone storage container.

7. The apparatus of claim 1, further comprising:
an energy conversion component connected to the energy-harvesting mechanism (250).

8. The apparatus of claim 1, wherein said energy storage device (240) comprises a thin-film battery with a total thickness that does not exceed 1 centimeter and/or wherein the lateral area of said thin-film battery does not exceed 10 square inches.

9. The apparatus of claim 8, wherein the lateral area of said thin-film battery does not exceed 0.25 square centimeters.

10. The apparatus of claim 8, wherein said thin-film battery contains a heat and pressure-resilient separation layer, a metallic lithium anode, a lithium-ion battery, and/or a lithium-free battery.

11. The apparatus of claim 8, wherein the electroactive element within said thin-film battery comprises lithium.

12. The apparatus of claim 3, wherein said portable device (100) comprises any device selected from the group of: wristwatch, iPod®, MP3 player, computer, cell phone, and personal digital assistant.

13. A method for communicating information associated with a moving human (110) comprising:
converting energy into useful form by an energy harvesting mechanism (250) that is embedded within an accessory (130) worn by the moving human (110);
storing said useful form of energy within the accessory (130);
powering a processing unit that is embedded in the accessory (130), with said stored energy;
monitoring at least one parameter with at least one sensor within the accessory;
receiving a signal from a portable device (100) that is located on the moving human (110) who is wearing the accessory (130) and changing an operating condition in the accessory (130) in response to the signal received from the portable device (110).

14. The method of claim 3, further comprising:
communicating monitored parameters to said processing unit;
processing said monitored parameters into user data; and
transmitting said user data.

15. The method of claim 13, further comprising:
receiving GPS signals from one or more GPS satellites (120);
determining location information from said GPS signals; and
transmitting location information.

16. The method of claim 13, further comprising:
transmitting signals to the portable device (100).

17. The method of claim 13, further comprising:
receiving signals from the portable device (100);
processing said signals into user data; and
transmitting said user data.

## Patentansprüche

1. Vorrichtung umfassend:
ein Zubehör (130), das eingerichtet ist, um durch einen sich bewegenden Menschen (110) getragen zu werden;
ein Energie-erntender Mechanismus (250), eingebettet in das Zubehör und
eingerichtet zum Umwandeln einer Kraft, die auf das Zubehör durch den sich bewegenden Menschen (110) ausgeübt wird, in eine geerntete Energie;
eine Energiespeichervorrichtung (240), verbunden mit dem Energie-erntenden Mechanismus (250) und eingerichtet zum Empfangen der geernteten Energie von dem Energie-erntenden Mechanismus (250) und Speichern der geernteten Energie;
ein Empfänger (380) zum Empfangen eines Signals von einer tragbaren Vorrichtung (100), welche an dem Menschen (110) positioniert ist, der das Zubehör trägt, und eine Leistungsmanagementeinheit (340), die mit der Energiespeichervorrichtung (240) verbunden ist;
ein Mikroprozessor (370) ist eingebettet in dem Zubehör und ist verbunden mit der Energiespeichervorrichtung (240) und ist eingerichtet zum Ändern einer Betriebsbedingung in dem Zubehör (130) in Reaktion auf das Signal, das von der tragbaren elektronischen Vorrichtung (100) empfangen wurde.

2. Vorrichtung nach Anspruch 1, wobei das Zubehör (130) einen beliebigen Artikel umfasst ausgewählt aus der Gruppe aus: Schuh, Sandale, Slipper, Stiefel, Alpin-Ski, Wasserski, Surfbrett, Snowboard, Roller Skate, Inline Skate, Schlitten, Hufeisen, Pferdesattel, Geschirr, Leine, Halsband.

3. Vorrichtung nach Anspruch 1, ferner umfassend mindestens einen Sensor, mindestens einen Signalsender, der eine Nachricht an die tragbare Vorrichtung (100) überträgt und wobei der Signalempfänger eingerichtet ist zum Empfangen von GPS-Signalen, verbunden mit dem Mikroprozessor (370).

4. Vorrichtung nach Anspruch 1, wobei der Energie-erntende Mechanismus (250) eine beliebige Vorrichtung umfasst ausgewählt aus der Gruppe aus: Piezoelektrischer Wandler, Funkwandler, Solarzelle, Windturbine, Vibrationsenergie-Ausbeuter, Wasserbewegung-zu-elektrischer-Energie-Konverter, Rotationsbewegung-zu-elektrischer-Energie-Konverter und Temperaturvariations-zu-elektrischer-Energie-Konverter.

5. Vorrichtung nach Anspruch 3, wobei der mindestens eine Sensor eine beliebige Vorrichtung umfasst ausgewählt aus der Gruppe aus: Höhenmesser, Druckmesser, Thermometer, Barometer, Hygrometer, Beschleunigungsmesser, Windmesser.

6. Vorrichtung nach Anspruch 1, wobei die Energiespeichervorrichtung eine beliebige Vorrichtung umfasst aus der Gruppe aus: Batterie, Dünnfilmbatterie, Kondensator, Dünnfilmkondensator, Magneto-elektrisches Element, Piezoelektrisches Element, Wärmemasse-Behälter, Schwungrad, Mikro-Schwungrad, Mikroelektro-mechanisches System (MEMS), mechanische Feder, Wasserstoffgenerator mit Wasserstoffbehälter, Ozongenerator mit Ozonspeicherbehälter.

7. Vorrichtung nach Anspruch 1, ferner umfassend:
eine Energieumwandlungskomponente, die mit dem Energie-erntenden Mechanismus (250) verbunden ist.

8. Vorrichtung nach Anspruch 1, wobei die Energiespeichervorrichtung (240) eine Dünnfilmbatterie umfasst mit einer absoluten Dicke, die einen Zentimeter nicht überschreitet und/oder wobei die seitliche Fläche der Dünnfilmbatterie 10 Quadratzoll nicht überschreitet.

9. Vorrichtung nach Anspruch 8, wobei die seitliche Fläche der Dünnfilmbatterie 0,25 Quadratzentimeter nicht überschreitet.

10. Vorrichtung nach Anspruch 8, wobei die Dünnfilmbatterie eine Hitze- und Druckbelastbare Trennschicht, eine metallische Lithium-Anode, eine Lithium-Ionen-Batterie und/oder eine Lithium-freie Batterie beinhaltet.

11. Vorrichtung nach Anspruch 8, wobei das elektroaktive Element in der Dünnfilmbatterie Lithium umfasst.

12. Vorrichtung nach Anspruch 3, wobei die tragbare Vorrichtung (100) eine beliebige Vorrichtung umfasst ausgewählt aus der Gruppe aus: Armbanduhr, iPod®, MP3-Player, Computer, Mobiltelefon und persönlicher digitaler Assistent.

13. Verfahren zum Kommunizieren von Information, die mit einem sich bewegenden Menschen (110) verknüpft ist, umfassend:
Umwandeln von Energie in eine geeignete Form durch einen Energie-erntenden Mechanismus (250), der eingebettet ist in ein Zubehör (130), das von dem sich bewegenden Menschen (110) getragen wird;
Speichern der geeigneten Form von Energie in dem Zubehör (130);
Antreiben einer Verarbeitungseinheit, die in das Zubehör (130) eingebettet ist, mit der gespeicherten Energie;
Überwachen mindestens eines Parameters mit dem mindestens einen Sensor in dem Zubehör;
Empfangen eines Signals von einer tragbaren Vorrichtung (100), die auf dem sich bewegenden Menschen (110) positioniert ist, der das Zubehör (130) trägt, und Ändern einer Betriebsbedingung in dem Zubehör (130) in Reaktion auf das Signal, das von der tragbaren Vorrichtung (110) empfangen wurde.

14. Verfahren nach Anspruch 3, ferner umfassend:
Kommunizieren überwachter Parameter an die Verarbeitungseinheit;
Verarbeiten der überwachten Parameter zu Benutzerdaten; und
Übertragen der Benutzerdaten.

15. Verfahren nach Anspruch 13, ferner umfassend:
Empfangen von GPS-Signalen von einem oder mehreren GPS-Satelliten (120);
Bestimmen von Positionsdaten aus den GPS-Signalen; und
Übertragen von Positionsdaten.

16. Verfahren nach Anspruch 13, ferner umfassend:
Übertragen von Signalen an die tragbare Vorrichtung (100).

17. Verfahren nach Anspruch 13, ferner umfassend:
Empfangen von Signalen von der tragbaren Vorrichtung (100);
Verbarbeiten der Signale zu Benutzerdaten; und
Übertragen der Benutzerdaten.

## Revendications

1. Un appareil comprenant:
un accessoire (130) adapté à être porté par un homme en mouvement (110) ;
un mécanisme de capture d'énergie (250) embarqué dans ledit accessoire et adapté pour convertir une force appliquée sur l'accessoire par l'homme en mouvement (110) en une énergie captée ;
un dispositif de stockage d'énergie (240) connecté audit mécanisme de capture d'énergie (250) et adapté à recevoir l'énergie captée du mécanisme de capture d'énergie (250) et
à stocker l'énergie captée ;
un récepteur (380) pour recevoir du dispositif portable (100) qui est positionné sur l'homme (110) portant l'accessoire et une unité de gestion de puissance (340) connecté audit dispositif de stockage d'énergie (240) ;
un microprocesseur (370) est embarqué dans l'accessoire et est connecté audit dispositif de stockage d'énergie (240) et est adapté pour modifier les conditions de fonctionnement dans l'accessoire (130) en réponse au signal reçu du dispositif électronique portable (100).

2. L'appareil selon la revendication 1, dans lequel ledit accessoire (130) comprend un article sélectionné parmi le groupe de : chaussure, sandale, chausson, botte, ski alpin, ski nautique, planche de surf, surf des neiges, patin à roulettes, roller en ligne, luge, fer à cheval, selle de cheval, harnais, laisse, collier.

3. L'appareil selon la revendication 1, en outre comprenant au moins un capteur, au moins un transmetteur de signal qui transmet un message au dispositif portable (100) et le récepteur de signal est adapté à recevoir des signaux GPS, connecté audit microprocesseur (370).

4. L'appareil selon la revendication 1, dans lequel ledit mécanisme de capture d'énergie (250) comprend un dispositif sélectionné parmi le groupe de : transducteur piézoélectrique, transducteur de fréquence radio, cellule solaire, turbine à vent, récupérateur d'énergie vibratoire, convertisseur de mouvement d'eau en énergie électrique, convertisseur de mouvement de rotation en énergie électrique, et convertisseur de variation de température en énergie électrique.

5. L'appareil selon la revendication 3, dans lequel ledit au moins un capteur comprend un dispositif sélectionné parmi le groupe de : altimètre, manomètre, thermomètre, baromètre, hygromètre, accéléromètre, anémomètre.

6. L'appareil selon la revendication 1, dans lequel ledit dispositif de stockage d'énergie comprend un dispositif sélectionné par le groupe de : batterie, batterie à couche mince, capacité, capacité à couche mince, élément magnétoélectrique, élément piézoélectrique, conteneur de masse thermique, volant d'inertie, micro volant d'inertie, systèmes microélectromécaniques, ressort mécanique, générateur hydrogène avec un conteneur hydrogène, générateur d'ozone avec un conteneur de stockage d'ozone.

7. L'appareil selon la revendication 1, en outre comprenant un composant de conversion d'énergie connecté au mécanisme de capture d'énergie (250).

8. L'appareil selon la revendication 1, dans lequel ledit dispositif de stockage d'énergie (240) comprend une batterie à couche mince ayant une épaisseur totale ne dépassant pas 1 centimètre et/ou dans lequel la zone latérale de ladite batterie à couche mince n'excède pas 10 pouces carré.

9. L'appareil selon la revendication 8, dans lequel la zone latérale de ladite batterie à couche mince n'excède pas 0.25 centimètre carré.

10. L'appareil selon la revendication 8, dans lequel la batterie à couche mince contient une couche de séparation supportant la chaleur et la pression, une anode lithium métallique, une batterie lithium-ion, et/ou une batterie dépourvue de lithium.

11. L'appareil selon la revendication 8, dans lequel l'élément électro actif dans ladite batterie à couche mince comprend du lithium.

12. L'appareil selon la revendication 13, dans lequel ledit dispositif portable (100) comprend un dispositif sélectionné parmi le groupe de : montre-bracelet, iPod®, lecteur MP3, ordinateur, téléphone cellulaire, et assistant digital personnel.

13. Une méthode pour communiquer des informations associées à un humain en mouvement (110) comprenant:
conversion d'énergie dans une forme utile par un mécanisme de capture d'énergie (250) qui est embarqué dans un accessoire (130) porté par l'homme en mouvement (110) ;
stockage de ladite forme utile d'énergie dans l'accessoire (130) ;
alimentation d'une unité de traitent qui est embarquée dans l'accessoire (130), avec ladite énergie stockée ;
surveillance d'au moins un paramètre avec au moins un capteur dans l'accessoire ;
réception d'un signal d'un dispositif portable (100) qui est localisé sur l'homme en mouvement (110) qui porte l'accessoire (130) et modification d'une condition de traitement dans 1"accessoire (130) en réponse au signal reçu du dispositif portable (110).

14. La méthode selon la revendication 3, en outre comprenant:
communication de paramètres surveillés à ladite unité de traitement ;
traitement desdits paramètres surveillés en données utilisateur ; et
transmission desdites données utilisateur.

15. La méthode selon la revendication 13, en outre comprenant:
réception de signaux GPS d'un ou plusieurs satellites GPS (120) ;
détermination d'information de localisation à partir desdits signaux GPS ; et
transmission d'information de localisation.

16. La méthode selon la revendication 13, en outre comprenant:
transmission de signaux au dispositif portable (100).

17. La méthode selon la revendication 13, en outre comprenant:
réception de signaux du dispositif portable (100) ;
traitement desdits signaux en données utilisateur ; et
transmission desdites données utilisateur.
